# EUROPEAN PATENT APPLICATION

(11) **EP 1 746 873 A1**
(43) Date of publication of application: **24.01.2007**
(21) Application number: 06014831.9
(22) Date of filing: 17.07.2006
(51) Int. Cl.: H05K 7/14, H05K 1/14

(54) **Modular broadband and bi-directional programmable switch with hot-swappable modules**

(30) Priority: 18.07.2005 US 183505
(71) Applicant: Quinteck Electronics & Communications, Inc., Indiana PA 15701 (US)
(72) Inventor: Phelps, Thomas B., Cowansville, Pennsylvania 16218 (US); Farich, Michael L., Pennsylvania 15679 (US); Baker, Bradley H., Commodore, Pennsylvania 15769 (US)
(74) Representative: Thacker, Darran Ainsley

(57) **Abstract**

A programmable switch for broadband signals having a modular design in which input cards, bridging cards and output cards are interconnected through a common backplane to form a switching matrix having a Clos architecture. All connections between cards are made through the backplane to decrease the complexity of the switch and are arranged to minimize the length of signal traces to minimize signal loss. The backplane is unique in that it is configured with venting holes to facilitate the flow of cooling air therethrough. All modules, including input cards, output cards and bridge cards are hot swappable.

## Description

### Field Of The Invention

This invention is related to the field of switching of electrical signals, specifically, signals ranging from DC to the gigahertz range, and, in particular, to improvements to a modular switching apparatus.

### Background Of The Invention

The state of the art in the switching of electrical signals, and in particular, signals in the RF frequency range, is currently a modular, programmable switch of the type disclosed in U.S. Patent 5,481,073 (Singer, et al.), which is incorporated herein by reference. This switch is modular, in that it is built from a plurality of identical switching modules, typically having a plurality of inputs/outputs which can be programmatically switched to a single input/output. By physically arranging the modules in a matrix fashion, that is, a plurality of modules stacked in a side-by-side fashion, with a second tiered plurality of modules, also stacked in a side-by-side fashion, a switch having an arbitrary number of inputs and an arbitrary number of outputs can be constructed, with any input being able to be switched to any output, in a single sub-system. Subsystems can be cabled together to form larger switches.

While the switch disclosed in Singer represented an advancement in the state of the art in switch design, several drawbacks have been identified and several improvements addressing those drawbacks are disclosed herein.

First, the construction of the switch disclosed in Singer is complicated in that, after the switch matrix is placed in an enclosure, it may be necessary to remove and/or disassemble the entire assembly of modules in order to remove a single module. It is also necessary to use cabling if it is desired to have the input and output connectors of the switch matrix in the same plane, such as the rear panel of a chassis. This makes the switch labor-intensive to construct and precludes repair of failed modules in the field. Additionally, it is impossible for an end user to upgrade existing switches (i.e., from 4 x 4 to 8 x 8 or 16x16) by adding or replacing modules in the field. Thus, in the event a single module fails in the field, an end user will have to send the entire unit in to the manufacturer for repair or upgrade. Therefore, it is a goal of the improved switch to provide the capability of repair and upgrade of the switch in the field, thereby eliminating the need to take the unit out of service for extended periods of time for shipment to and from the factory for repair.

Second, the current switches are physically large in size. Customers typically mount the switches in 48.3 cm (19 inch) racks of the type used for mounting electrical equipment, with a switch chassis having a 3U form factor. Often, rack space may be limited. Current state of the art switches can fit a 16 x 16 switch in a 3U chassis, with larger switches requiring multiple 3U chassis with inter-chassis cabling to accomplish the necessary switching. For example, a 32x32 switch requires four 16 x 16 switch modules, two 16 x 4 signal distribution modules, two 4 x 16 output switch modules, and takes 24U of rack space. The number of chassis required increases by the square of the size increase. Doubling the size of a matrix requires four times as many switch chassis along with additional support chassis. Therefore, it would be desirable to increase the number of inputs and outputs available in a single chassis, and for this chassis to be as small as possible..

### Brief Summary of the Invention

The next generation modular switch has design enhancements which remedy the deficiencies in the current state of the art modular switch. The switch consists of a backplane into which input and output boards are plugged, as well as boards which bridge the input and output boards. This modular design eliminates internal cabling and the layout of the backplane allows the removal and replacement of all boards without disturbing other boards in the system, allowing the hot swappable, in field servicing of the switches. Initial assembly of the units is also greatly simplified, representing a savings in labor costs to assemble the units. Further, the next generation switch disclosed herein also has a high level of redundancy, allowing re-routing of connections in the event of a failure of one or more components, and the capability of self-diagnosis of faulty boards. The new modular design also provides a savings in physical space requirements, allowing a 32 x 32 switch in a 6U chassis form factor.

The preferred embodiment of the switch, having 32 inputs and 32 outputs (i.e., 32 x 32), consists of 8 input cards, each having 4 inputs, 8 output cards, each having 4 outputs, and 4 bridge cards bridging the input and output cards. However, varying configurations are possible. In a 6U chassis, configurations from 4 x 4 to 32 x 32 are possible. Configurations from 36 x 36 to 1024 x 1024 or larger are possible, but require multiple 6U chassis.

The input cards each have four inputs connected via the backplane to connectors on the rear of the chassis. For signals in the RF range, F, BNC, SMA or N style connectors are typically used, but the chassis may be configured with any type of connectors. Additionally, each input and output may be configured to have a 50 Ω or 75 Ω impedance. The input cards also each have 8 outputs and integrated splitters, so each input card is in actuality, a complete 4 x 8 matrix. Likewise, the output cards each have four outputs connected to the rear of the chassis via the backplane, 8 inputs and integrated splitters, so each output card is a complete 8 x 4 matrix.

The input and output cards are bridged by 8 x 8 switching matrices, thereby allowing any input to be routed to any output. In the preferred embodiment, each bridging card will have two 8 x 8 switching matrices. In a full-blown, 32 x 32 implementation, there are eight 8 x 8 switching matrices, with each of the 8 outputs of each input card being connected to an input on a different 8x8 switching matrix, such that each 8 x 8 matrix receives a signal from all input cards. Likewise, each of the 8 inputs of the output cards are connected to an output on a different 8 x 8 matrix, such that each 8 x 8 matrix supplies a signal to all output cards.

The backplane of the switch is laid out in a unique manner such as to minimize trace length, and thereby minimize signal loss as the signals are routed from the inputs to the outputs. The switch is also configured such that all components (i.e., all input and output cards, as well as the bridging cards) are accessible from the front of the unit and are hot-swappable without the need to disconnect cables or disassemble the units. All cards simply plug into the backplane utilizing standard off the shelf connecting hardware and hardware to secure the cards in place within the chassis. Input and output cards are also keyed to prevent their insertion into the wrong slots.

### Brief Description Of The Drawings

Figure 1 is a logic diagram showing connections between input, output and bridge cards as well as a connection to the unit controller.
Figure 2 shows a layout of the connectors for the input cards, the output cards and the bridge cards on the backplane.
Figure 3 shows one layer of the backplane having holes cut therein to enhance air flow.
Figure 4 is a upper level architecture diagram of an input and output card.
Figure 5 is a upper level architecture of a circuit that could be used for self diagnostics.
Figure 6 is an overall architecture diagram of the system.
Figure 7 shows a front of the cabinet of the switches showing the layout of the input cards, the output cards, power supplies and bridge cards.
Figure 8 is a top view of the switch showing the layout of the backplane, the input, the output and power cards.

### Detailed Description Of The Preferred Embodiment

The switch of the current invention solves problems with backplane complexity, number of boards, space required and internal cabling complexity by using a different type of matrix architecture than is known in the prior art in this area. The architecture, known as a Clos or 3-stage matrix, is non-standard in the RF switching art, but is known in the prior art in other segments of the electronics industry. The Clos architecture builds a large matrix from smaller submatrices in a multilayer format.

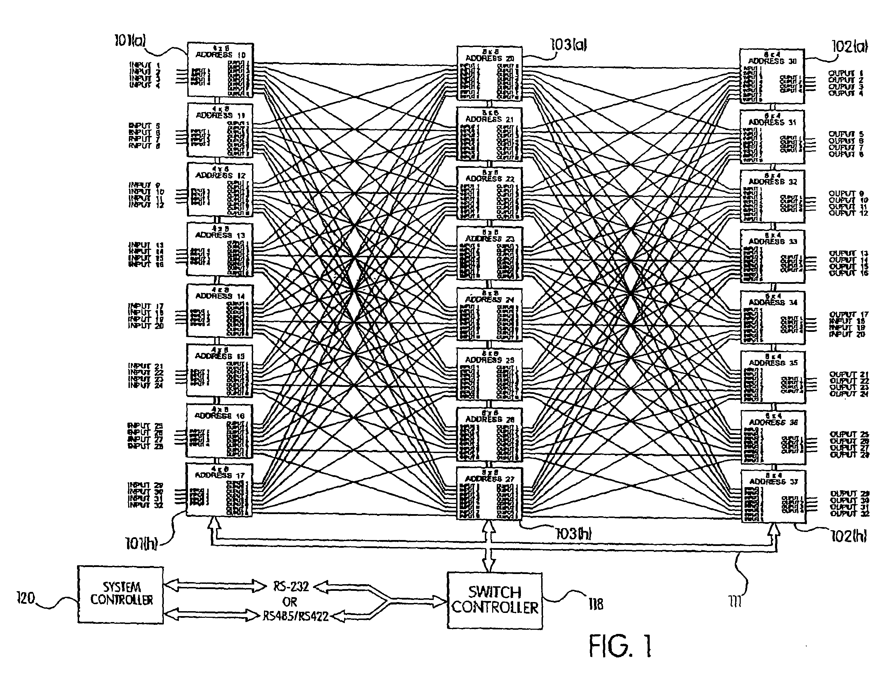

In the preferred embodiment of the invention, as shown in Figure 1, there are eight input cards, each having a 4 x 8 matrix, four bridge cards, each having two 8x 8 matrices and eight output cards, each having an 8 x 4 matrix, with standard splitter switch architecture. The eight input cards, four bridge cards and eight output cards are arranged in a three stage Clos matrix architecture to form a 32 x 32 switching matrix. The architecture requires only 128 connections between cards as opposed to the 1024 connections required if building a matrix with a standard single stage matrix architecture. Because all cards plug into a common backplane, all connections to the cards are handled by on-board traces rather than by actual cables, as was the case in the prior art. The reduced number of connections greatly decreases the complexity and the number of connectors required, which also lowers the cost to manufacture.

Referring to Figure 1, input matrices 101(a) through 101(h) are shown on the left hand side thereof, each having four inputs and eight outputs. The inputs to these cards are connected either directly or through the backplane via RF signal cables or a PCB to standard connectors on the back of the chassis of the unit, to a standard connector, typically either an F connector or a BNC connector, although any type of standard or non-standard connector can be used. The outputs of matrices 101(a) through 101(h) are connected to the inputs of bridge matrices 103(a) through 103(h) in the manner shown. That is, output 1 of matrix 101(a) is connected to input 1 of bridge matrix 103(a). Output 2 of matrix 101 (a) is connected to input 1 of bridge matrix 103(b), and so on as shown. The outputs of bridge matrices 103(a) to 103(h) are connected in a similar fashion to the inputs of output matrices 102(a) through 102(h). Output matrices 102(a) through 102(h) each have four outputs which are connected to the back of the chassis of the unit. Thus, it is possible to route the signals from any input on any of input cards 101 (a) to any of output cards 102(a) through 102(h) via a plurality of different routes such that if one route is not available because of a bad card, other routes may be available. The 3-stage architecture having eight 4 x 8 input cards and eight 8 x 4 output cards bridged by eight 8 x 8 matrices, provides a minimum of eight paths from any given input to any given output.

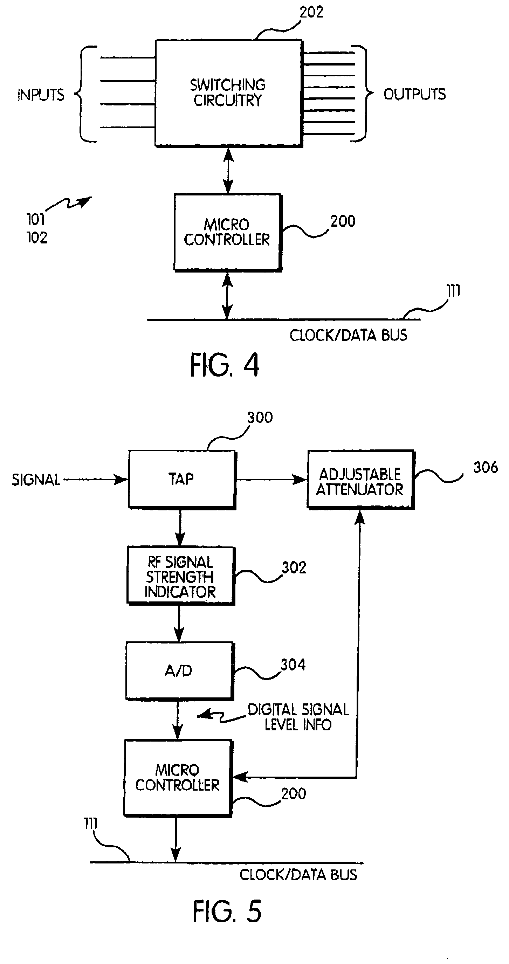

Figure 4 shows the architecture of the cards carrying the input and output matrices. They comprise switching circuitry 202 which is controlled by microcontroller 200. With respect to the input matrices, microcontroller 200 is able to cause any of the four inputs to switching circuitry 202 be routed to any of the eight outputs from switching circuitry 202. Note that Figure 4 shows an input matrix card, 101 however, the output matrix cards 102 are identical in architecture, with the difference being that the output matrices have eight inputs and four outputs instead of the four inputs and eight outputs.

The cards carrying bridge matrices 103(a) through 103(h) are also similar in design, however, having eight inputs and eight outputs controlled by a microcontroller 200. Additionally, bridging matrices 103(a) through 103(h) are arranged two per physical card, to facilitate the arrangement of the cards within the chassis of the unit and the to simplify the layout of backplane 110.

Switch controller 118 shown on Figure 1 is connected via a clock / data bus 111 to the microcontroller 200 on each of the input cards 101(a) through 101(h), bridge cards 103(a) through 103(h) and output cards102(a) through 102(h). Switch controller 118 is able to accept commands, preferably via an RS-232 or RS-485 connection, from another device. The main commands consist of a source and a destination, indicating which of 32 inputs should be connected to which of the 32 outputs. Switch controller 118 is then able to send commands to configure individual microcontrollers on individual input cards 101(a) through 101(h), bridge cards 103(a) through 103(h) and output cards 102(a) through 102(h). For example, to route a signal from input 6 to output 24 it may be possible to use any one of eight different routes through the switch. First it will be necessary to configure input card 101(b) into which input 6 is routed to route input 6 to one of eight outputs on input card 101 (a), thereby routing the signal to one of bridge cards 103(a) through 103(h). Switch controller 118 then configures the particular bridge card through which the signal is routed to route the signal from whatever input it is being received on to output 6, which will route the card to output card 102(f). Switch controller 110 then instructs the microcontroller 200 on output card 102(f) to route the signal from whatever input it is being received on to output 24. Note that if any one of bridge cards 103(a) through 103(h) is defective in any manner, the signal may be routed through any of the other bridge cards. Likewise, any input 1-32 can be routed to any output 1-32. Therefore, if a bad circuit exists on one of input cards 101 (a) through 101(h) or any of output cards 102(a) through 102(h), the signal can be rerouted by manually moving the cables to another input or another output and instructing switch controller 118 to route the signal from the particular input chosen to the particular output chosen.

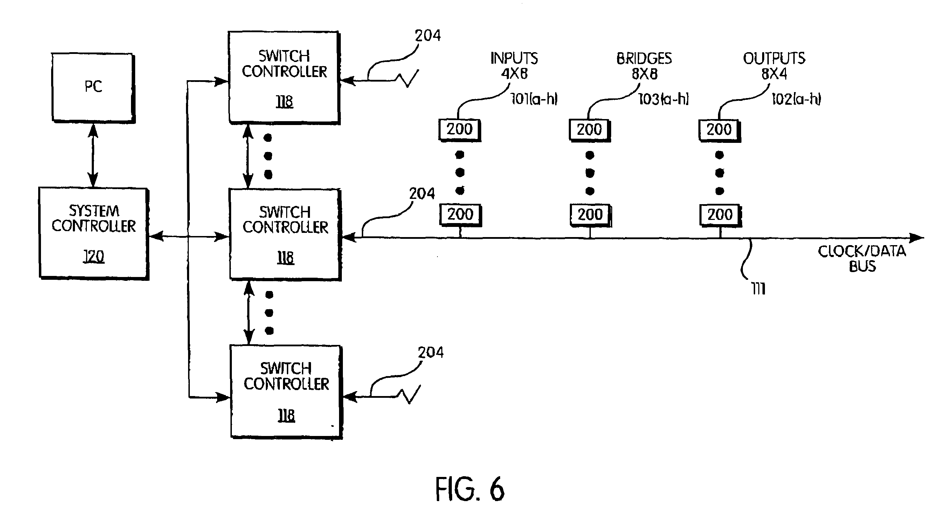

Figure 1 also shows system controller 120 which is responsible for communicating with switch controller 110. System controller 120 serves two functions. First, a user interface is provided which is available to a PC connected via any known means to the system controller 120 such as by internet connection or serial connection. In addition, system controller 120 sends commands to the switch controller 118 instructing it to route various inputs to various outputs. Referring to Figure 6, which shows an architecture wherein multiple switches are being used in conjunction with each other to provide a larger matrix, such as a 256 x 256 matrix, system controller 120 can be instructed to route a signal from an input on one switch unit to the output on another switch unit and will send the appropriate commands to the switch controller 118 on each individual switch unit to affect the routing of the signal.

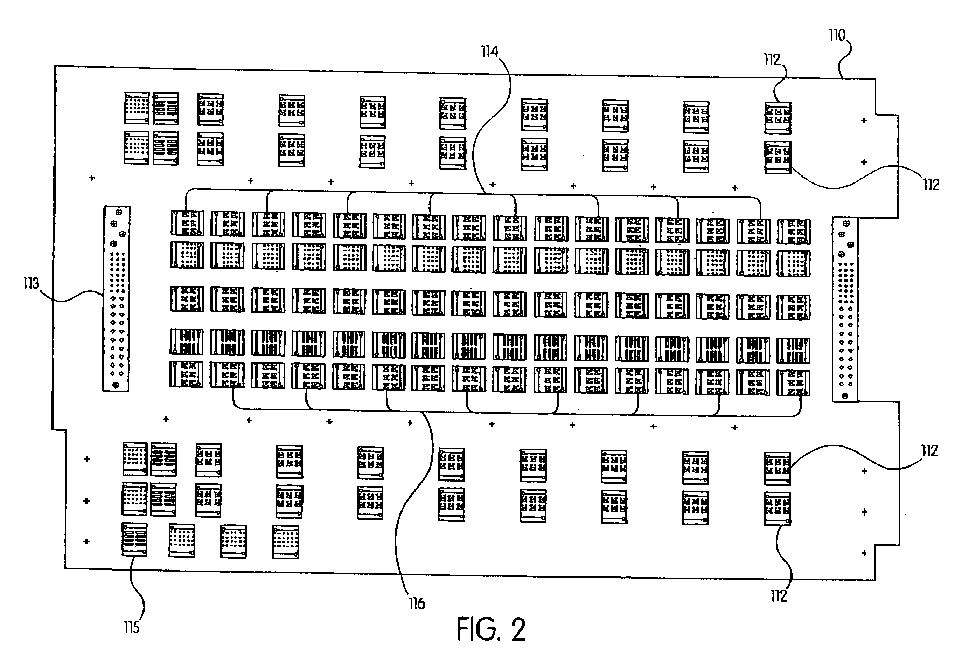

In one novel aspect of the invention, the input, bridge and output cards are arranged to be plugged into backplane 110 to eliminate internal cabling therebetween. The layout of the backplane 110 is shown in Figure 2. To minimize signal trace length on the board and the length of cables used to connect the inputs and outputs to the to the connectors on the back of the chassis, input cards are mounted in connectors 114 and output cards are mounted in connectors 116 in an alternating fashion. This also minimizes the length of cables used to connect to the connectors on the back of the chassis of the unit. Connectors 112 are capable of accepting four bridge cards which, in the preferred embodiment of the invention, each have two 8 x 8 switching matrices thereon. Connectors 113 on either side of the array of input and output connectors serve as connectors for power supplies 104 and connectors 115 shown on the bottom of backplane 110 serve as a connector for a card which contains switch controller 118.

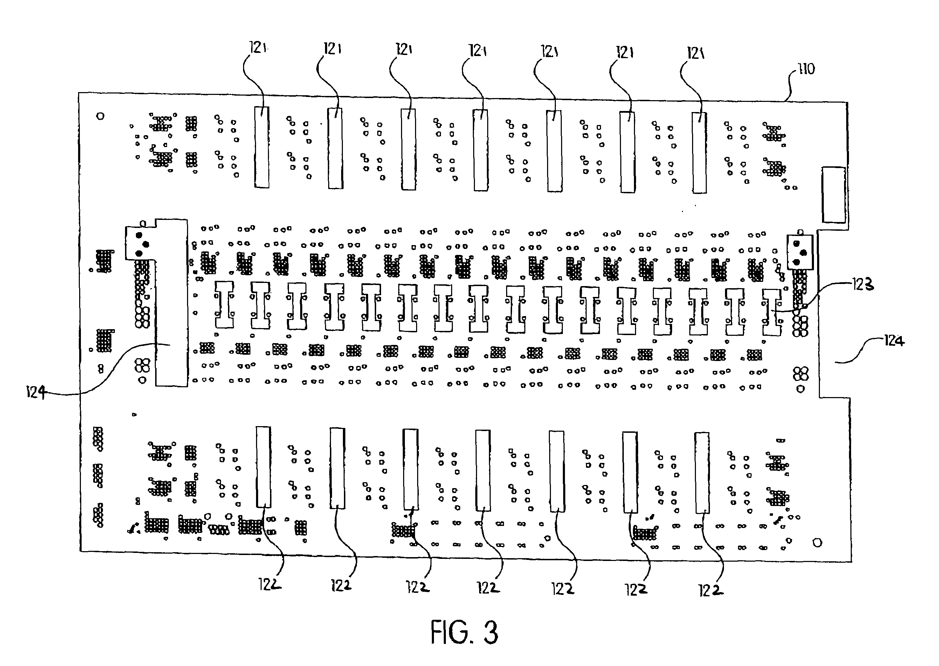

One difficulty with the layout of the backplane card 110 shown in Figure 2 is that vertical air flow necessary to cool the input and output cards is restricted by the presence of the bridge cards, which plug into connectors 112 in a horizontal manner. Therefore, the backplane can be configured as shown in Figure 3 with holes 121 along the top of the card, holes 122 along the bottom of the card, holes 123 in between the input and output cards and holes 124 on either side adjacent to power supplies 104. These openings in the card allow the flow of air therethrough from a fan unit mounted in the rear of the chassis of the unit to cool all of the cards. The switching traces are routed around the openings in the card.

In another novel aspect of the invention, it is possible to provide self-diagnostic circuitry as shown in Figure 5, on each of the input, bridge, and output cards to determine if individual inputs and outputs of each card are operating in the proper manner. To perform the diagnosis, tap 300 taps into the signal present on a particular input or output line and routes the signal through an RF signal strength indicator 302 which provides an analog indicator of the signal strength. This is converted to digital signal level information by an A/D converter 304 and is then fed to on-board microcontroller 200. Microcontroller 200 compares the signal strength at an output to the original signal at an input and indicates whether or not the strength of the two signals are within acceptable boundaries. If not, an error may be indicated to switch controller 118 through the clock / data bus 111. It is also possible to provide a similar circuit on the inputs and outputs that are routed to the back of the switch unit. This allows diagnosis of problems with individual inputs and outputs at the rear of the unit that allow diagnosis down to the board and/or a specific input or output level. Additionally, the presence of attenuator 306 on the input or output allows to the ability of the switch to adjust the signal level of the input or output for purposes of improving channel-to-channel isolation and matching the signal levels required by other equipment.

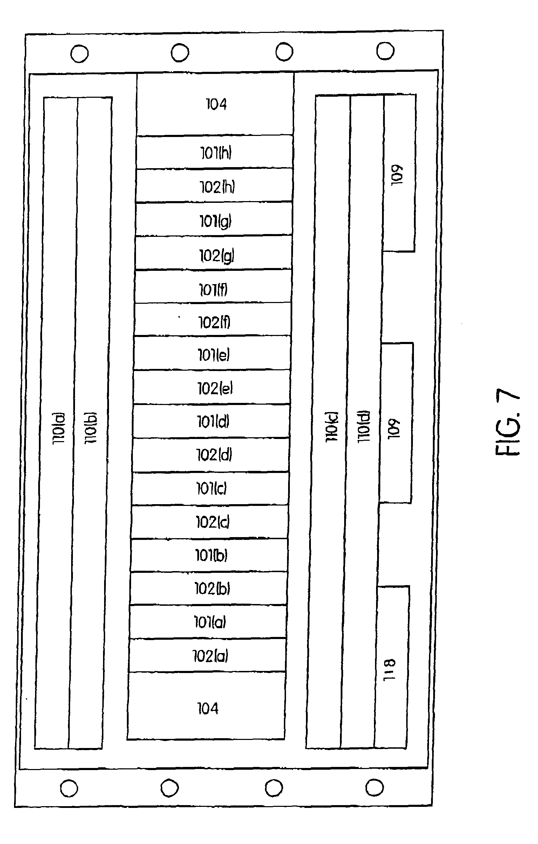

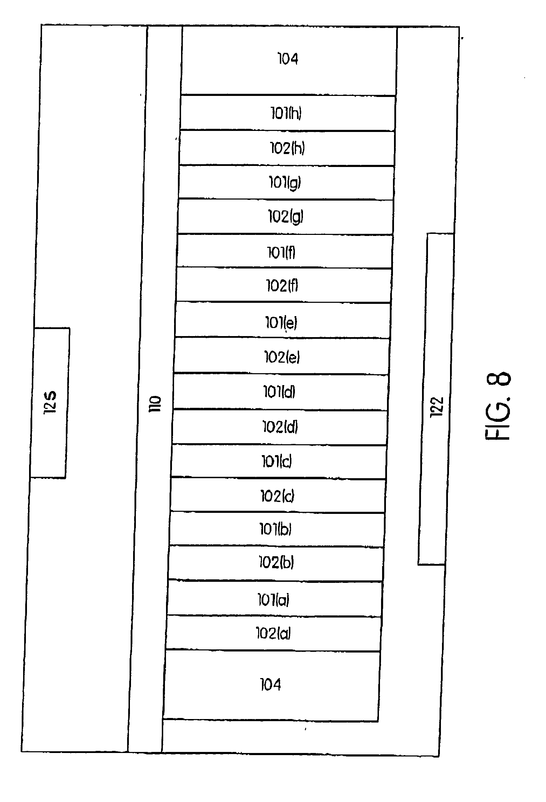

Figure 7 shows a front view of the preferred embodiment of the switch showing the layout thereof. Output cards 102(a) through 102(h) and inputs cards 101(a) through 101(h) are arranged in an interlaced manner across the middle of the unit, with power supplies 104 located on either side thereof. Bridge cards 110(a) through 110(d) are shown with two at the top of the input and output cards and two at the bottom thereof. Note that this architecture also allows the backplane of the unit to be split in half for easier manufacture, because half of the input and output signals are routed to the upper bridge cards, and half are routed to the lower bridge cards. Switch controller 118 is shown in the lower left hand corner of the unit and blocks 109 represent options which may be installed into the system. The top view of the switch is shown in Figure 8 wherein power supplies 104 and inputs and outputs 102(a) through 102(h) and 101(a) through 101(h), respectively, are shown connected to backplane 110. Fan unit 125 as shown in the rear of backplane 110 and is capable of drawing air through the holes 121, 122, 123 and 124 defined by backplane 110.

In the preferred embodiment of the invention, the switch unit itself contains 32 inputs and 32 outputs, however there is no reason why any configuration, typically in groups of four inputs and outputs could not be configured. In other words, it is not necessary that the entire chassis be filled with cards if a matrix smaller than 32 x 32 is required. It may also be possible and is contemplated to be within the scope of this invention to create larger input and output cards and larger bridge cards to create a larger overall matrix within one chassis or several sub-chassis. It is also possible to combine multiple 32 x 32 units to create the a larger matrix, for example, a 256 x 256 matrix or any size in between 32 x 32, by providing cable connections between the boxes and by utilizing system controller 120 to control the routing of the signals between the boxes.

A further advantage of the layout and architecture of the switch is that defective boards can be hot swapped for replacement or upgrade. In one embodiment of the invention, the unit is capable of telling the operator that board needs to be swapped and, in addition may also tell the operator which input or output of which board is nonfunctional, if equipped with the self-diagnostic circuitry shown in Figure 5. The system is also capable of automatically rerouting signals between inputs and outputs to compensate for bad routes until a defective board can be swapped. If one of bridge cards 103(a) through 103(h) is dysfunctional, it would be possible to reroute the signal in a manner that is invisible to the user, i.e., this would not require the switching of cables from an input on the back of the unit to an output on the back of the unit, however, the manual switching of cables may be unavoidable if the defect occurs in one of input cards 101(a) through 101(h) or output cards 102(a) through 102(h).

The bridge cards connect to the backplane at right angles to the input and output cards, such that a bridge card will span all the input and output cards. This arrangement, along with the alternating arrangement of the input and output cards and arranging the bridge cards above and below the input and output cards provides an optimally efficient routing of signals on backplane 110 and reduces the number of layers required in the backplane PBC and thus makes it easier to manufacture. Additionally, the shortest possible routings on the backplane PCB 110 minimize signal loss between matrices. In addition, all input, bridge and output cards are accessible from the front of the unit, which allows customers to maintain or expand the switch unit with ease and is a novel point which provides a major advantage over competing products.

The illustrations, layouts, materials, and dimensions used herein are exemplary in nature only and are not meant to limit the scope of the invention, which is embodied in the claims which follow.

## Claims

1. A modular, programmable switch comprising:
one or more backplane cards (110);
one or more input cards (101), each of said input cards (101) having one or more input switching matrices thereon, each of said input switching matrices having n inputs and m outputs;
one or more bridge cards (103), each of said bridge cards (103) having one or more bridge switching matrices thereon, each of said bridge switching matrices having m inputs and m outputs; and
one or more output cards (102), each of said output cards (102) having one or more output switching matrices thereon, each of said output switching matrices having m inputs and n outputs;
wherein all of said input cards (101), said bridge cards (103) and said output cards (102) are connected to said backplane card (110) and further wherein all connections between said input cards (101), said bridge cards (103) and said output cards (102) are made via traces defined on said backplane card (110).

2. A switch according to Claim 1, wherein said input switching matrices, said bridge switching matrices and said output switching matrices are inter-connected through said one or more backplane cards (110) in a 3-stage matrix network architecture.

3. A switch according to Claim 1 or Claim 2 wherein any of said n inputs on any of said one or more input cards (101) can be programmatically connected to any of said n outputs on any of said one or more output cards (102).

4. A switch according to any preceding Claim, wherein said input switching matrices, said bridge switching matrices and said output switching matrices are arranged on said one or more backplane cards (110) to minimize the length of said traces on said one or more backplane cards (110).

5. A switch according to any preceding of Claim, wherein said bridge cards (103) are connected to said one or more backplane cards (110) at right angles to said input cards (101) and said output cards (102).

6. A switch according to any preceding Claim, wherein any of said input cards (101), said bridge cards (103) and said output cards (102) may be removed from said one or more backplane cards (110) while said switch maintains connections utilizing said remaining input cards (101), bridge cards (103) and output cards (102).

7. A switch according to any preceding of Claim, further comprising a plurality of microcontrollers (200), disposed one each on said one or more input (101), bridge (103) and output cards (102), said microcontrollers (200) being capable of accepting commands to effect the routing of signals within individual input, bridge and output switching matrices.

8. A switch according to Claim 7, wherein:
said microcontroller (200) on each of said input cards (101) can effect a connection between any of said n inputs and any of said m outputs;
said microcontroller (200) on each of said bridge cards (103) can effect a connection between any of said m inputs and any of said m outputs; and
said microcontroller (200) on each of said output cards (102) can effect a connection between any of said m inputs and any of said n outputs;
thereby forming a path through said switch from any of said n inputs on any of said one or more input cards (101) and any of said n outputs on any of said one or more output cards (102).

9. A switch according to Claim 7 or 8, further comprising a switch controller (118), coupled to each of said microcontrollers (200) for each of said input, bridge and output switching matrices and capable of exchanging digital data therebetween; for sending said commands accepted by said microcontrollers (200) for effecting the routing of signals within individual input, bridge and output switching matrices.

10. A switch according to Claim 9, wherein said switch controller (118) is mounted on a card which plugs into said one of said one or more backplane cards (110) and further wherein said switch controller (118) is coupled to said plurality of microcontrollers (200) through a data bus (111) defined by traces on said one or more backplane cards (110).

11. A switch according to any preceding Claim, wherein said switch is housed in a chassis and further where each of said n inputs on said one or more input switching matrices and each of said n outputs on said one or more output switching matrices are accessible external to said chassis via a connector mounted on an exterior wall of said chassis.

12. A switch according to Claim 11, wherein each of said input (101), bridge (103) and output (102) cards are accessible through a door defined in said chassis and may be installed or removed therethrough.

13. A switch according to any preceding Claim, wherein said one or more backplane cards (110) define a plurality of holes (121, 122, 123, 124) therethrough to effect the flow of air from a fan unit (125) mounted behind said one or more backplane cards (110) for the purpose of cooling said one or more input cards (101), said one or more bridge cards (103) and said one or more output cards (102).

14. A switch according to any preceding Claim, further comprising one or more power supply cards (104) mounted on cards plugged into said one or more backplane cards (110) and further wherein said input cards (101), said bridge cards (103) and said output cards (102) all receive power through said one or more backplane cards (110).

15. A switch according to Claim 9, further comprising a self-diagnostic capability comprising circuitry (300, 302, 304, 306), associated with each of input, bridge and output switching matrices, to detect a non-functional or sub-functional input or output associated with any switch matrix and for reporting via said microcontroller (200), to said switch controller (118).

16. A switch according to any Claim 15, wherein said circuitry detects a differential in the signal strength of any input to and any output from any switch matrix.

17. A switch according to Claim 15 or Claim 16, further comprising means for instructing a user of said switch to replace one or more of said input (101), bridge (103) or output cards (102) based on the detection of a card which is non-functional or sub-functional.

18. A switch according to Claims 15 to 17, wherein said switch controller (118) can automatically re-route signals based on the detection of a non-functional or sub-functional routing.

19. A switch according to Claim 9, further comprising a system controller (120) in communication with said switch controller (118), for providing an interface for a user to said switch controller (118) and for allowing the combining of said switch with other, similar switches to provide a larger switching capability having more inputs and output than are available in a single chassis switch.

20. A switch according to Claim 19, wherein said system controller (120) communicates with said switch controller of individual switches to effect the routing of a signal from the input of one switch to the output of another switch.
